(19) Europäisches Patentamt / European Patent Office / Office européen des brevets

(11) **EP 4 181 265 B1**

(12) **EUROPEAN PATENT SPECIFICATION**

(45) Date of publication and mention
of the grant of the patent:
**05.03.2025 Bulletin 2025/10**

(21) Application number: **21837215.9**

(22) Date of filing: **25.06.2021**

(51) International Patent Classification (IPC):
*G06Q 10/20* (2023.01)   *G06Q 30/018* (2023.01)
*G06Q 50/40* (2024.01)   *H01M 10/42* (2006.01)
*H01M 10/48* (2006.01)   *H02J 7/00* (2006.01)
*G01R 31/396* (2019.01)   *G01R 31/3842* (2019.01)
*G01R 31/385* (2019.01)

(52) Cooperative Patent Classification (CPC):
**G01R 31/3842; G01R 31/385; G06Q 10/20;
G06Q 30/0185; G06Q 50/40; H01M 10/42;
H01M 10/48;** H01M 2010/4278; H02J 7/0048;
Y02E 60/10

(86) International application number:
**PCT/JP2021/024121**

(87) International publication number:
**WO 2022/009696 (13.01.2022 Gazette 2022/02)**

(54) **ARITHMETIC SYSTEM, BATTERY INSPECTION METHOD, AND BATTERY INSPECTION PROGRAM**

ARITHMETISCHES SYSTEM, BATTERIEPRÜFVERFAHREN UND BATTERIEPRÜFPROGRAMM

SYSTÈME ARITHMÉTIQUE, PROCÉDÉ D'INSPECTION DE BATTERIE, ET PROGRAMME D'INSPECTION DE BATTERIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **08.07.2020 JP 2020117734**

(43) Date of publication of application:
**17.05.2023 Bulletin 2023/20**

(73) Proprietor: **Panasonic Intellectual Property
Management Co., Ltd.
Osaka-shi, Osaka 540-6207 (JP)**

(72) Inventors:
• **NISHIKAWA, Shinya**
**Osaka-shi, Osaka 540-6207 (JP)**
• **IIDA, Takashi**
**Osaka-shi, Osaka 540-6207 (JP)**
• **SADA, Tomokazu**
**Osaka-shi, Osaka 540-6207 (JP)**

(74) Representative: **Novagraaf International SA
Chemin de l'Echo 3
1213 Onex, Geneva (CH)**

(56) References cited:
WO-A1-2020/045033   JP-A- 2010 019 664
JP-A- 2018 116 839   US-A1- 2019 036 356
US-A1- 2020 209 319

**Description**

TECHNICAL FIELD

The present disclosure relates to an arithmetic system, a battery inspection method, and a battery inspection program for inspecting a battery mounted on a product.

BACKGROUND ART

Hybrid vehicles (HV), plug-in hybrid vehicles (PHV), and electric vehicles (EV) have become widespread in recent years. On these electrically-driven vehicles, a secondary battery such as a lithium ion battery is mounted as a key device. There is a case where a defective product is mixed in a battery pack mounted on an electrically-driven vehicle or an unauthorized product is used. Examples of a case where an unauthorized product is used include use of a battery of a type different from catalog specifications and use of a battery having a capacity smaller than that described in the catalog specifications (for example, about 10% less).

As a method of detecting a defect or degradation of a battery, a method of detecting an abnormality of a battery by inputting a high-frequency wave (see, for example, Patent Literature 1) and a method of detecting degradation of a battery based on a change in an open circuit voltage (OCV) curve (see, for example, Patent Literature 2) have been proposed.

Citation List

Patent Literature

PTL 1: Unexamined Japanese Patent Publication No. 9-133741
PTL 2: Unexamined Japanese Patent Publication No. 2010-19664

Document WO 2020/045033 discloses an arithmetic system reflecting the preamble of present claim 1. Further art is disclosed by the document JP 2018 116839, which discloses a management server including a reception section for receiving a physical quantity via a network, a storage section for storing the received physical quantity, an operation section for calculating information about the state of the power storage device, on the basis of the stored physical quantity, and an information provision section for providing the information about the state of the power storage device thus calculated to a management terminal and a portable terminal. In addition, document US2020/209319A1 discloses an arithmetic system for analysing the state of batteries in electric vehicles, but not that a determination is made if a given battery is of a type that is in conformity with specifications of a given electrically driven vehicle.

SUMMARY OF THE INVENTION

However, it is difficult to detect that a battery different from the catalog specifications is used. Since it is necessary to evaluate a battery of another company instead of a battery of an own company, it is not easy to obtain characteristics of the battery in advance, and it takes cost and time to obtain the characteristics.

The present disclosure has been made in view of such situation, and its object is to provide a technique capable of easily detecting whether or not a battery different from product specifications is used.

In order to solve the above problem, an arithmetic system according to the present invention is defined in the appended claims and includes: a data acquisition unit that acquires operation data at least including a voltage and a state of charge (SOC) of a battery mounted on a same product from a plurality of individuals of the product via a network; and a detector that statistically processes a plurality of acquired operation data to detect an individual on which a battery different from specifications of the product is mounted.

Any combinations of the above configuration elements and conversions of the expressions of the present disclosure among methods, devices, systems, computer programs, and the like are still effective as aspects of the present disclosure.

According to the present disclosure, it is possible to easily detect whether or not a battery different from product specifications is used.

BRIEF DESCRIPTION OF THE DRAWINGS

Fig. 1 is a view for explaining an arithmetic system used by a plurality of business operator systems according to an exemplary embodiment.

Fig. 2 is a view for explaining a detailed configuration of a battery system mounted on an electrically-driven vehicle.

Fig. 3 is a view for explaining an estimation method of an FCC.

Fig. 4 is a view illustrating a configuration example of the business operator system and the arithmetic system illustrated in Fig. 1.

Figs. 5(a) and (b) are views illustrating an example of travel data.

Fig. 6 is a flowchart illustrating a flow of estimation processing of SOC-OCV characteristics of a battery module by the arithmetic system.

Fig. 7 is a view illustrating an example of a graph in which a plurality of SOC-OCV characteristics of battery modules mounted on a plurality of electrically-driven vehicles of a specific vehicle type are plotted.

Fig. 8 is a view illustrating an example of a histogram of Mahalanobis distances between a median of SOC-OCV characteristics and each SOC-OCV characteristic at a certain SOC value.

Fig. 9 is a view illustrating a graph in which the median of SOC-OCV characteristics and SOC-OCV characteristics including an outlier are left from the graph of Fig. 7.

Fig. 10 is a flowchart illustrating a flow of a first processing example for the arithmetic system to detect whether or not a battery module different from catalog specifications by is mounted.

Fig. 11 is a flowchart illustrating a flow of a second processing example for the arithmetic system to detect whether or not a battery module different from catalog specifications by is mounted.

Fig. 12 is a view illustrating a shape of a line connecting three points of a median.

Fig. 13 is a flowchart illustrating a flow of a third processing example for the arithmetic system to detect whether or not a battery module different from catalog specifications by is mounted.

## DESCRIPTION OF EMBODIMENT

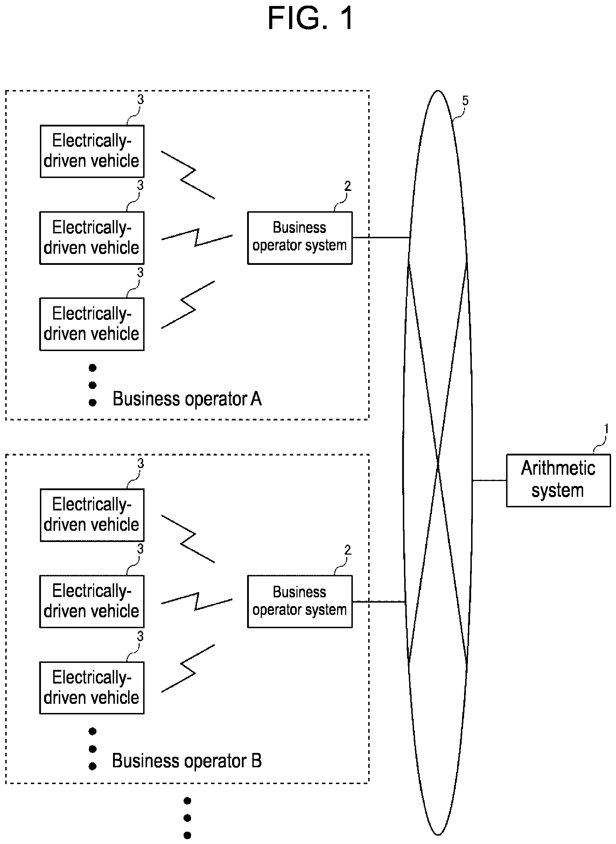

Fig. 1 is a view for explaining arithmetic system 1 used by a plurality of business operator systems 2 according to an exemplary embodiment. A plurality of business operators A and B each have a plurality of electrically-driven vehicles 3 and run a business using the plurality of electrically-driven vehicles 3. For example, each business operator utilizes the plurality of electrically-driven vehicles 3 to run a delivery business (home delivery business), a taxi business, a rental car business, or a car sharing business. In the present exemplary embodiment, a pure EV not mounted with an engine is assumed as electrically-driven vehicle 3.

Each of business operators A and B includes business operator system 2. Business operator system 2 is a system for managing the work of each of business operators A and B. Business operator system 2 is configured of one or a plurality of information processing devices (for example, servers and PCs). Some or all of the information processing devices constituting business operator system 2 may be present in a data center. For example, business operator system 2 may be configured by combination of a server (own business server, cloud server, or rental server) in the data center and a client PC in the business operator.

Arithmetic system 1 is configured of one or a plurality of information processing devices installed in a data center. Business operator system 2 can access arithmetic system 1 via network 5. Network 5 is a general term of communication paths such as the Internet and leased lines, regardless of a communication medium or a protocol.

The plurality of electrically-driven vehicles 3 are parked in a parking lot or a garage of a business office of each of business operators A and B during waiting. The plurality of electrically-driven vehicles 3 have a wireless communication function and can perform wireless communication with business operator system 2. The plurality of electrically-driven vehicles 3 transmit, to business operator system 2, travel data including operation data of a mounted secondary battery. During traveling, electrically-driven vehicle 3 may wirelessly transmit the travel data to a server constituting business operator system 2 via network 5. For example, the travel data may be transmitted at a frequency of once every 10 seconds. Alternatively, the travel data for one day may be transmitted in batch at a predetermined timing once a day (for example, at the end of business hours).

In a case where business operator system 2 is configured of an own business server or a PC installed in the business office, electrically-driven vehicle 3 may transmit travel data for one day to the own business server or the PC after returning to the business office after the end of business hours. In that case, the travel data may be wirelessly transmitted to the own business server or the PC, or may be connected to the own server or the PC by wire and transmitted via wired communication. Alternatively, the travel data may be transmitted to the own business server or the PC via a recording medium in which the travel data is recorded. In the case where business operator system 2 is configured of combination of a cloud server and a client PC in the business office, electrically-driven vehicle 3 may transmit the travel data to the cloud server via the client PC in the business office.

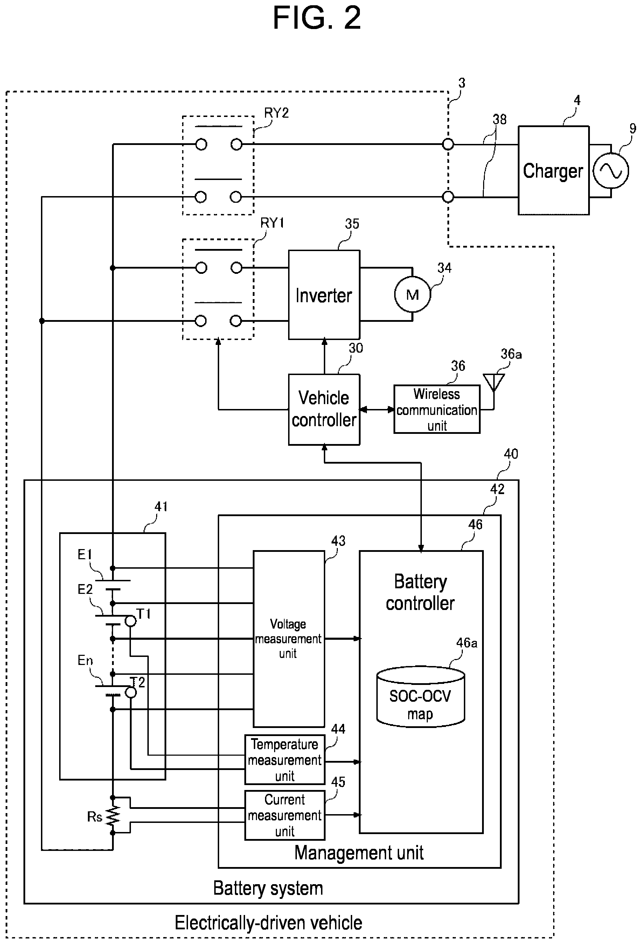

Fig. 2 is a view for explaining a detailed configuration of battery system 40 mounted on electrically-driven vehicle 3. Battery system 40 is connected to motor 34 through first relay RY1 and inverter 35. At the time of power running, inverter 35 converts DC power supplied from battery system 40 into AC power and supplies the power to motor 34. At the time of regeneration, AC power supplied from motor 34 is converted into DC power and supplied to battery system 40. Motor 34 is a three-phase AC motor, and rotates in accordance with the AC power supplied from inverter 35 at the time of power running. At the time of regeneration, rotational energy due to deceleration is converted into AC power and supplied to inverter 35.

First relay RY1 is a contactor provided in wiring connecting battery system 40 and inverter 35. Vehicle controller 30 causes first relay RY1 to an on-state (closed state) during traveling, and electrically connects battery system 40 to a power system of electrically-driven vehicle 3. Vehicle controller 30 generally causes first relay RY1 to an off-state (open state) at the time of not traveling, and electrically interrupts battery system 40 from the power system of electrically-driven vehicle 3. Instead of the relay, another type of switch such as a semiconductor switch may be used.

Battery system 40 can be charged from commercial power system 9 by being connected to charger 4 installed outside electrically-driven vehicle 3 with charging cable 38. Charger 4 is connected to commercial power system 9 and charges battery system 40 in electrically-driven vehicle 3 using charging cable 38. In electrically-driven vehicle 3, second relay RY2 is provided in wiring connecting battery system 40 and charger 4. Instead of the relay, another type of switch such as a semiconductor switch may be used. Management unit 42 of battery system 40 causes second relay RY2 into the on-state (closed state) before start of charging, and into the off-state (open state) after end of charging.

In general, an alternating current is used for normal charging, and a direct current is used for quick charging. In the case of charging with the alternating current, AC power is converted to DC power by an AC/DC converter (not illustrated) provided between second relay RY2 and battery system 40.

Battery system 40 includes battery module 41 and management unit 42, and battery module 41 includes a plurality of cells E1 to En connected in series. Battery module 41 may be configured of a plurality of battery modules connected in series or series/parallel. For each of the cells, a lithium-ion battery cell, a nickel metal hydride battery cell, a lead battery cell, or the like can be used. Hereinafter, in the present description, an example of use of a lithium ion battery cell (nominal voltage of 3.6 V to 3.7 V) is assumed. The number of series connections of cells E1 to En is determined in accordance with a drive voltage of motor 34.

Shunt resistor Rs is connected in series with the plurality of cells E1 to En. Shunt resistor Rs functions as a current detection element. Instead of shunt resistor Rs, a Hall element may be used. Inside of battery module 41 is provided with a plurality of temperature sensors T1 and T2 for detecting temperature of the plurality of cells E1 to En. One temperature sensor may be provided in the battery module, or one temperature sensor may be provided for each of a plurality of cells. For example, a thermistor can be used for temperature sensors T1 and T2.

Management unit 42 includes voltage measurement unit 43, temperature measurement unit 44, current measurement unit 45, and battery controller 46. Nodes of the plurality of cells E1 to En connected in series and voltage measurement unit 43 are connected via a plurality of voltage lines. Voltage measurement unit 43 measures voltage of each of cells E1 to En by measuring voltage between two adjacent voltage lines. Voltage measurement unit 43 transmits the measured voltage of each of cells E1 to En to battery controller 46.

Because voltage measurement unit 43 is high in voltage with respect to battery controller 46, voltage measurement unit 43 and battery controller 46 are connected via a communication line in an insulated state. Voltage measurement unit 43 can be configured of an application specific integrated circuit (ASIC) or a general-purpose analog front-end integrated circuit (IC). Voltage measurement unit 43 includes a multiplexer and an A/D converter. The multiplexer outputs the voltage between two adjacent voltage lines to the A/D converter in order from the top. The A/D converter converts an analog voltage input from the multiplexer into a digital value.

Temperature measurement unit 44 includes a voltage dividing resistor and an A/D converter. The A/D converter sequentially converts, into digital values, a plurality of analog voltages divided by the plurality of temperature sensors T1 and T2 and a plurality of the voltage dividing resistors, and outputs the digital values to battery controller 46. Battery controller 46 estimates temperatures of the plurality of cells E1 to En based on the digital values. For example, battery controller 46 estimates the temperature of each of cells E1 to En based on a value measured by the temperature sensor most adjacent to the corresponding one of cells E1 to En.

Current measurement unit 45 includes a differential amplifier and an A/D converter. The differential amplifier amplifies voltage across shunt resistor Rs and outputs the voltage to the A/D converter. The A/D converter converts, into a digital value, the voltage input from the differential amplifier and outputs the digital value to battery controller 46. Battery controller 46 estimates a current flowing through the plurality of cells E1 to En based on the digital value.

In a case where an A/D converter is mounted in battery controller 46 and an analog input port is provided in battery controller 46, temperature measurement unit 44 and current measurement unit 45 may output analog voltages to battery controller 46, and the A/D converter in battery controller 46 may convert the analog voltages into digital values.

Battery controller 46 manages a state of the plurality of cells E1 to En based on the voltage, the temperature, and the current of the plurality of cells E1 to En measured by voltage measurement unit 43, temperature measurement unit 44, and current measurement unit 45, respectively. Battery controller 46 and vehicle controller 30 are connected via an in-vehicle network. For example, a controller area network (CAN) or a local interconnect network (LIN) can be used as the in-vehicle network.

Battery controller 46 can be configured of a microcomputer and a nonvolatile memory (for example, an EEPROM or a flash memory). SOC-OCV map 46a is held in the microcomputer or the nonvolatile memory. SOC-OCV map 46a describes characteristic data of SOC-OCV curves of the plurality of cells E1 to En. The SOC-OCV curves of the plurality of cells E1 to En are created in advance by a battery manufacturer and registered in the microcomputer or the nonvolatile memory at the time of shipment. The battery manufacturer conducts various tests to derive the SOC-OCV curves of cells E1 to En.

Battery controller 46 estimates the SOC, the FCC, and the SOH of each of the plurality of cells E1 to En. Battery controller 46 estimates the SOC by combining an OCV method and a current integration method. The OCV method is a method to estimate the SOC based on the OCV of each of cells E1 to En measured by voltage measurement unit 43 and the characteristic data of the SOC-OCV curve described in SOC-OCV map 46a. The current integration method is a method to estimate the SOC based on the OCV at the start of charging and discharging of each of cells E1 to En and an integrated value of the current measured by current measurement unit 45. In the current integration method, a measurement error of current measurement unit 45 accumulates as the charge and discharge time increases. Therefore, it is preferable to correct the SOC estimated with the current integration method using the SOC estimated with the OCV method.

Based on the characteristic data of the SOC-OCV curve described in SOC-OCV map 46a and the OCVs at two points of a cell measured by voltage measurement unit 43, battery controller 46 can estimate the FCC of the cell.

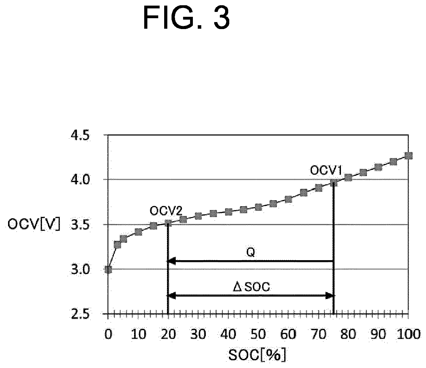

Fig. 3 is a view for explaining the estimation method of the FCC. Battery controller 46 acquires the OCVs at two points of a cell. With reference to the SOC-OCV curve, battery controller 46 specifies SOCs at two points respectively corresponding to voltages at the two points, and calculates a difference $\Delta$SOC between the SOCs at the two points. In the example illustrated in Fig. 3, the SOCs at the two points are 20% and 75%, and the $\Delta$SOC is 55%.

Based on time transition of the current measured by current measurement unit 45, battery controller 46 calculates current integration amount (= charge and discharge capacity) Q in a period between the time points at the two point where the two OCVs are acquired. Battery controller 46 can estimate the FCC by calculating the following (Equation 1).

$$FCC = Q/\Delta SOC \ ... \quad (Equation\ 1)$$

SOH is defined as a ratio of the present FCC to the initial FCC, and the lower the value (closer to 0%) is, the more degradation progresses. Battery controller 46 can estimate the SOH by calculating the following (Equation 2).

$$SOH = Present\ FCC/Initial\ FCC \ ... \quad (Equation\ 2)$$

The SOH may be obtained by capacity measurement by complete charging and discharging, or may be obtained by adding storage degradation and cycle degradation. The storage degradation can be estimated based on the SOC, the temperature, and the storage degradation rate. The cycle degradation can be estimated based on the SOC range to be used, the temperature, the current rate, and the cycle degradation rate. The storage degradation rate and the cycle degradation rate can be derived in advance by an experiment or a simulation. The SOC, the temperature, the SOC range, and the current rate can be obtained by measurement.

The SOH can also be estimated based on a correlation with an internal resistance of a cell. The internal resistance can be estimated by dividing, by the current value, a voltage drop occurring when a predetermined current flows through the cell for a predetermined time. There is a relationship in which the higher the temperature, the lower the internal resistance becomes, and there is a relationship in which the lower the SOH, the higher internal resistance becomes.

Battery controller 46 notifies, via the in-vehicle network, vehicle controller 30 of the voltage, the current, the temperature, the SOC, the FCC, and the SOH of the plurality of cells E1 to En. Vehicle controller 30 generates operation data of the plurality of cells E1 to En including identification information, type information, voltage, current, temperature, SOC, and measurement time of the plurality of cells E1 to En, and travel data including identification information and vehicle type information of electrically-driven vehicle 3. The operation data of the plurality of cells E1 to En does not include the FCC and the SOH. The travel data may include data such as speed data and travel position data of electrically-driven vehicle 3.

Wireless communication unit 36 performs signal processing for wirelessly connecting to network 5 via antenna 36a. In the present exemplary embodiment, wireless communication unit 36 wirelessly transmits the travel data acquired from vehicle controller 30 to business operator system 2. As a wireless communication network with which electrically-driven vehicle 3 can wirelessly connect, a cellular phone network (cellular network), a wireless local area network (LAN), an electronic toll collection system (ETC), dedicated short range communications (DSRC), vehicle-to-infrastructure (V2I), and vehicle-to-vehicle (V2V) can be used.

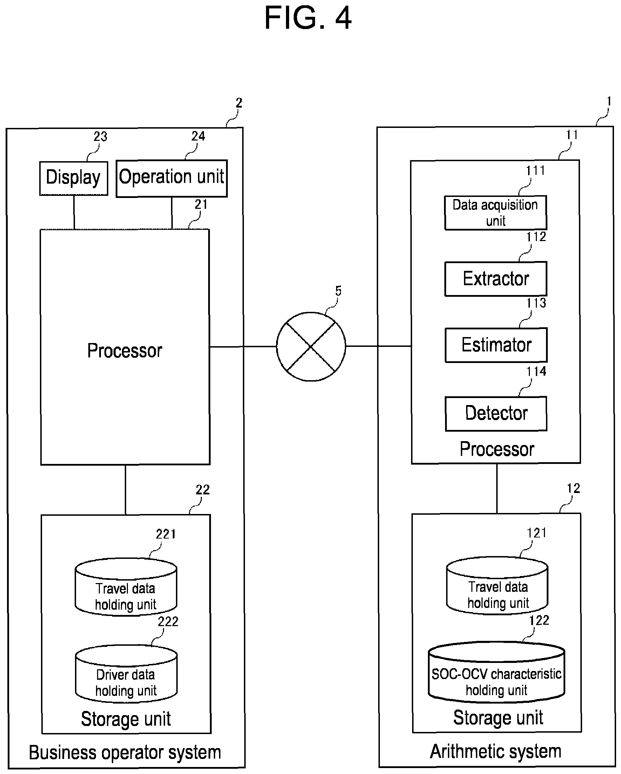

Fig. 4 is a view illustrating a configuration example of business operator system 2 and arithmetic system 1 illustrated in Fig. 1. Business operator system 2 includes processor 21, storage unit 22, display 23, and operation unit 24.

The function of processor 21 can be achieved by cooperation of a hardware resource and a software resource, or by the hardware resource alone. As the hardware resource, a CPU, a graphics processing unit (GPU), a ROM, a RAM, an ASIC, a field programmable gate array (FPGA), and another large-scale integration (LSI) can be used. As the software resource, an operating system, an application, and another program can be used. Storage unit 22 includes travel data holding unit 221 and driver data holding unit 222. Storage unit 22 includes a nonvolatile recording medium such as a hard disk drive (HDD) and a solid state drive (SSD), and records various types of programs and data.

Travel data holding unit 221 holds travel data collected from the plurality of electrically-driven vehicles 3 owned by a business operator. Driver data holding unit 222 holds data of a plurality of drivers belonging to a business operator. For example, a cumulative travel distance of each electrically-driven vehicle 3 that is driven is managed for each driver.

Display 23 includes a display such as a liquid crystal display or an organic EL display, and displays an image generated by processor 21. Operation unit 24 is a user interface such as a keyboard, a mouse, and a touchscreen, and accepts operation by a user of business operator system 2.

Business operator system 2 can provide arithmetic system 1 with travel data of the plurality of electrically-driven vehicles 3 held in travel data holding unit 221. This data provision is performed based on a contract between each of business operators A and B and an operating entity of arithmetic system 1. This contract may be a contract in which each of business operators A and B receives a financial consideration in return for the data provision, or may be a contract in which each of business operators A and B receives a benefit related to service use in return for the data provision. Alternatively, each of business operators A and B may provide the travel data for free.

Business operator system 2 can ask arithmetic system 1 for inspection as to whether battery module 41 different from the catalog specifications is mounted on electrically-driven vehicle 3 purchased by the business office. The inspection service of battery module 41 that is mounted may be charged or free for charge. For example, the inspection service may be a service that can be used by the business operator for free in return for data provision.

Arithmetic system 1 includes processor 11 and storage unit 12. Processor 11 includes data acquisition unit 111, extractor 112, estimator 113, and detector 114. The function of processor 11 can be achieved by cooperation of a hardware resource and a software resource, or by the hardware resource alone. As the hardware resource, a CPU, a GPU, a ROM, a RAM, an ASIC, an FPGA, and another LSI can be used. As the software resource, an operating system, an application, and another program can be used. Storage unit 12 includes travel data holding unit 121 and SOC-OCV characteristic holding unit 122. Storage unit 22 includes a nonvolatile recording medium such as a HDD and a SSD, and records various types of programs and data.

Travel data holding unit 121 holds travel data of the plurality of electrically-driven vehicles 3 collected from each of business operators A and B. SOC-OCV characteristic holding unit 122 holds SOC-OCV characteristics created by processor 11 based on the collected travel data. The SOC-OCV characteristics may be held in units of cells or in units of battery modules 41. Hereinafter, in the present exemplary embodiment, travel data holding unit 121 is assumed to hold SOC-OCV characteristics of battery module 41 for each identical vehicle type.

Data acquisition unit 111 acquires travel data of electrically-driven vehicles 3 from the plurality of business operators A and B, and stores the acquired travel data in travel data holding unit 121. Extractor 112 extracts, as sample data, sets of SOCs and voltages at a plurality of times included in the operation data of the plurality of battery modules 41 held in travel data holding unit 121. At that time, extractor 112 extracts the sets of SOC and voltage in a period in which the voltage can be considered as the OCV (that is, a period in which the cell is regarded to be in a resting state).

The secondary battery is an electrochemical product, and a measured voltage rises nonlinearly when a charge current flows through the secondary battery, and the measured voltage drops nonlinearly when a discharge current flows through the secondary battery. The voltage measured when the current flows through the secondary battery is a closed circuit voltage (CCV) containing an overvoltage component, and has a value separated from the OCV In a general lithium-ion battery cell, the measured voltage converges to the vicinity of the OCV not containing the overvoltage component in about 30 seconds after the end of charging and discharging. Depending on the material used for the negative electrode, the time until the voltage converges to the vicinity of the OCV varies. For example, in an negative electrode material mixed with silicon, it takes one hour or more until the voltage converges to the vicinity of the OCV.

Extractor 112 may extract, from the sets of SOC and voltage at a plurality of times, a set of SOC and voltage included in a period in which the value of the current is zero and a predetermined time (for example, 30 seconds) has elapsed from the end of charging and discharging (after the value of the current becomes zero).

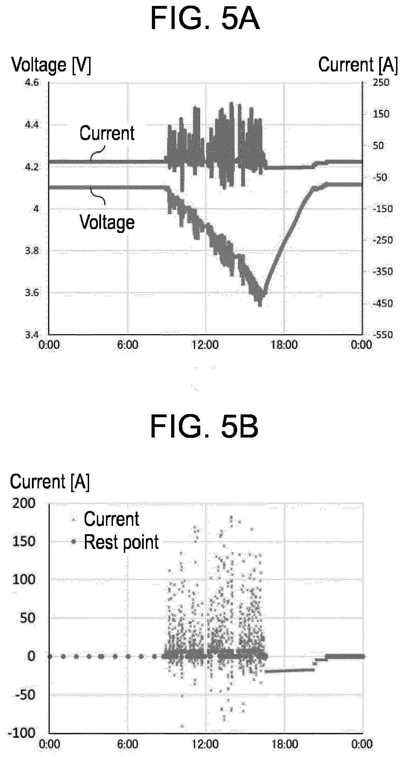

Figs. 5A and 5B are views illustrating an example of travel data. Fig. 5A is a view illustrating an example of time transition of voltage and current included in travel data for a certain day. Fig. 5B is a view measurement points of current for a certain day are plotted. Small circles indicate measurement points of the current measured while electrically-driven vehicle 3 is traveling. Large circles indicate measurement points of the current measured while electrically-driven vehicle 3 is stopping. That is, the large circles indicate rest points where no current flows. As illustrated in Figs. 5A and 5B, there are many rest points in the travel data, and it is possible to acquire a large number of voltages that can be regarded as OCVs from the travel data.

Furthermore, in order to increase the number of samples that can be extracted, the extraction condition may be relaxed. Extractor 112 may also set, as an extraction target, a set of SOC and voltage in a period in which a current value less than or equal to a set value (for example, 1 A or 0.1 C) continues for more than or equal to a set time (for example, one minute). That is, in this case, a period in which a current at a charge and discharge rate of less than or equal to 0.1 C or a current of less than or equal to 1 A continues for one minute in battery module 41 is defined as a period that can be regarded as the OCV or a period in which the cell is regarded to be in a resting state).

Estimator 113 generates an approximate curve based on the sample data of the plurality of points extracted by extractor 112, and estimates the SOC-OCV characteristics of battery module 41. Estimator 113 stores the estimated SOC-OCV characteristics in SOC-OCV characteristic holding unit 122.

Estimator 113 may separately generate the SOC-OCV characteristics for charging and the SOC-OCV characteristics for discharging of battery module 41. In this case, extractor 112 separately extracts the set of SOC and voltage in a period that is regarded as a resting state after the end of the charging to battery module 41 and the set of SOC and voltage in a period that is regarded as a resting state after the end of the discharging from battery module 41.

Estimator 113 may estimate the SOC-OCV characteristics based only on the sample data of battery module 41 whose use period is shorter than a predetermined period (for example, one year). The SOC estimated by management unit 42 of electrically-driven vehicle 3 has relatively high accuracy in a state where battery module 41 is almost new. In general, as the use period of a cell becomes longer, the accuracy of the SOC estimated by management unit 42 generally decreases. In particular, in management unit 42 that does not have a mechanism for updating the held SOC-OCV characteristics according to the use period of battery module 41, the accuracy of SOC is likely to decrease.

From above, the estimation accuracy of the SOC-OCV characteristics become higher in estimating the SOC-OCV characteristics based only on the sample data of battery module 41 with a short use period than in estimating the SOC-OCV characteristics based on the sample data of the entire period. The SOC-OCV characteristics may be estimated based only on the sample data of a cell in which the cumulative value of the charge/discharge current of battery module 41 is smaller than a predetermined value instead of battery module 41 whose use period of battery module 41 is shorter than the predetermined period.

The SOC-OCV characteristics of battery module 41 depends on the temperature and the degradation degree. Extractor 112 may classify and extract the sample data of battery module 41 based on at least one of a temperature section and a degradation degree section. Estimator 113 may generate the SOC-OCV characteristics of battery module 41 by mapping with at least one section of the temperature section and the degradation degree section based on the sample data classified for each section. As described above, when the operation data of each battery module 41 includes the identification information for uniquely specifying each battery module 41, the degradation degree of each battery module 41 can be estimated based on the cumulative value of the use period and the charge/discharge current of each battery module 41.

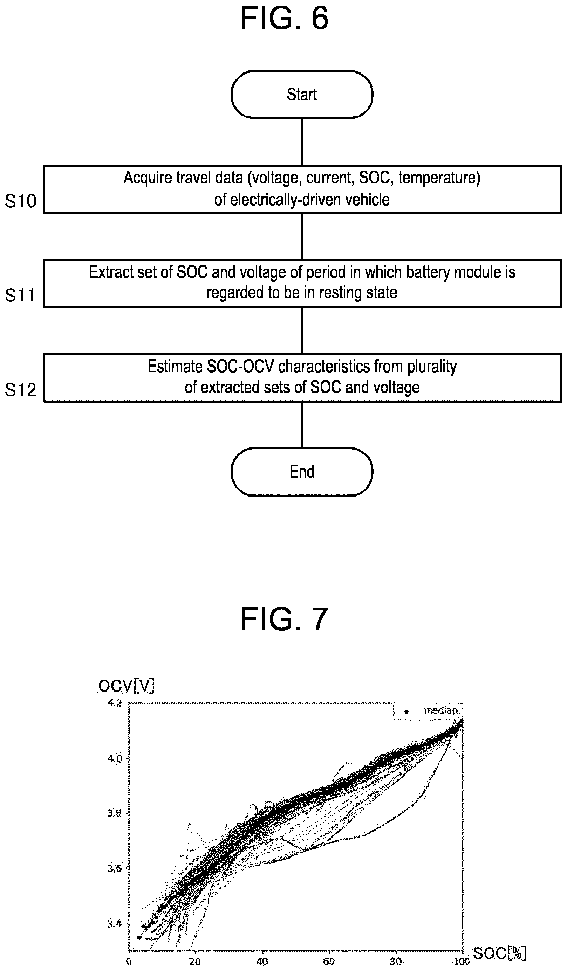

Fig. 6 is a flowchart illustrating the flow of estimation processing of SOC-OCV characteristics of battery module 41 by arithmetic system 1. Data acquisition unit 111 acquires travel data (including voltage, current, SOC, and temperature of battery module 41) of electrically-driven vehicle 3 from business operator system 2 (S10). Data acquisition unit 111 stores the acquired travel data in travel data holding unit 121. Extractor 112 extracts, from the travel data held in travel data holding unit 121, a set of SOC and voltage in a period in which battery module 41 is regarded to be in a resting state (S11). Estimator 113 generates an approximate curve based on the plurality of extracted sets of SOC and voltage and estimates the SOC-OCV characteristics (S12). Estimator 113 stores the estimated SOC-OCV characteristics in SOC-OCV characteristic holding unit 122.

Hereinafter, a method for inspecting whether battery module 41 different from the catalog specifications is mounted on electrically-driven vehicle 3 purchased by the business office will be described. Even if the catalog describes that only one type of battery module 41 is used, there is a case where another type of battery module 41 is mounted on electrically-driven vehicle 3 that is actually purchased. For example, there is a case where the catalog describes that a ternary lithium ion battery is used but an iron phosphate lithium ion battery is actually used. Even if battery module 41 of the same type as battery module 41 described in the catalog is mounted on electrically-driven vehicle 3 that is actually purchased, there is a case where battery module 41 having a small capacity is used.

It is practically difficult for a business office to disassemble battery system 40 of electrically-driven vehicle 3 and check the specifications of battery module 41, and a method for simply inspecting whether battery module 41 different from the catalog specifications is mounted is required. Detector 114 of arithmetic system 1 statistically processes a plurality of travel data of the same vehicle type as the inspection target, and inspects whether or not battery module 41 different from the catalog specifications is mounted. A detailed description will be given below.

Fig. 7 is a view illustrating an example of a graph in which a plurality of SOC-OCV characteristics of battery modules 41 mounted on a plurality of electrically-driven vehicles 3 of a specific vehicle type are plotted. As described above, for each electrically-driven vehicle 3 of the vehicle type, extractor 112 extracts, as sample data, a set of SOC and voltage in a period in which battery module 41 is regarded to be in a resting state, the set being specified based on the current, from a set of SOC and voltage at a plurality of times included in the travel data. Estimator 113 estimates the SOC-OCV characteristics of battery module 41 mounted on each electrically-driven vehicle 3 of the vehicle type based on the extracted sample data. In order to highly accurately detect battery module 41 different from the catalog specifications, it is desirable to have been able to collect the SOC-OCV characteristics of a large number of electrically-driven vehicles 3 (individuals) of the vehicle type.

Detector 114 specifies a median of the plurality of SOC-OCV characteristics. In Fig. 7, a series of the largest black dots indicates the median of the plurality of SOC-OCV characteristics. Detector 114 calculates a distance between the median of the SOC-OCV characteristic and each SOC-OCV characteristic. Specifically, detector 114 calculates the distance between the median of the SOC-OCV characteristic and each SOC-OCV characteristic for each SOC value (for example, every 1%). The distance may be a Euclidean distance or a Mahalanobis distance.

Although the following description presents an example in which an individual on which a battery different from specifications of the product is mounted is detected based on the distance between the median of the plurality of SOC-OCV characteristics and each SOC-OCV characteristic for each SOC value, the median of the plurality of SOC-OCV characteristics is not necessarily required. Specifically, the calculation may be performed using another representative value such as an average or a mode of a plurality of SOC-OCV characteristics. The configuration using a representative value such as the median of a plurality of SOC-OCV characteristics has a feature that an individual on which a battery different from specifications of the product is mounted can be detected even when the specifications of the product is unknown. However, when the SOC-OCV characteristics are recorded in advance in a memory or the like as specifications of the product, the distance between the value of the SOC-OCV characteristics recorded in advance and each SOC-OCV characteristic for each SOC value may be calculated. Typically, SOC-OCV curves of the product specifications can be derived by conducting various tests.

Mahalanobis distance d is a distance normalized by a standard deviation $\sigma$ as illustrated in the following (Equation 3).

$$d^2 = (x - m)^2/\sigma^2 \dots \quad \text{(Equation 3)}$$

x indicates the Euclidean distance of each sample from the median of the OCV.
x indicates an average of the Euclidean distance of each sample.
$\sigma$ indicates the standard deviation of the Euclidean distance of each sample.

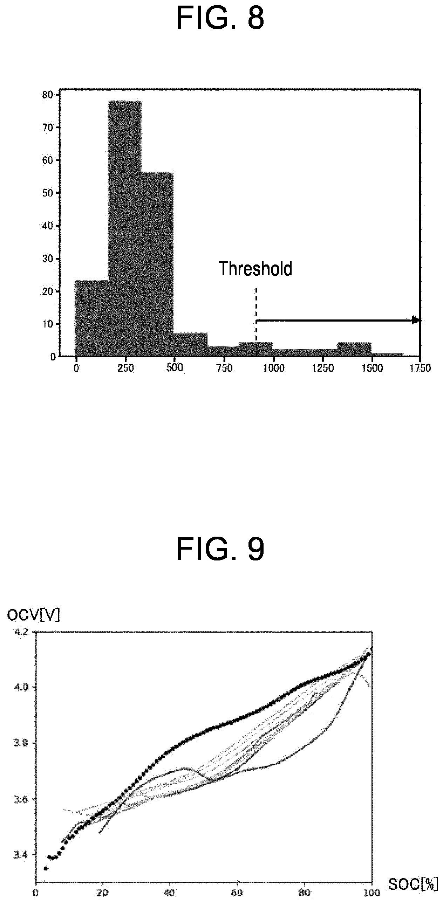

Fig. 8 is a view illustrating an example of the histogram of Mahalanobis distances between a median of SOC-OCV characteristics and each SOC-OCV characteristic at a certain SOC value. Detector 114 determines a value exceeding a threshold as an outlier. For example, a value of $3\sigma$ may be used as the threshold. In the case of normal distribution, since 99.7% falls within $3\sigma$, a value exceeding $3\sigma$ can be determined as an outlier. An optimal threshold may be adaptively changed by learning. Detector 114 calculates an outlier for each SOC value, and determines SOC-OCV characteristics including the outlier as those of electrically-driven vehicle 3 on which battery module 41 different from the catalog specifications is mounted.

Fig. 9 is a view illustrating a graph in which the median of SOC-OCV characteristics and SOC-OCV characteristics including an outlier are left from the graph of Fig. 7. The median of the SOC-OCV characteristics is an upwardly convex curve, and the SOC-OCV characteristics including the outlier show a downwardly convex curve. That is, it is estimated that the SOC-OCV characteristics of normal battery module 41 described in the catalog of a specific vehicle type shows an upwardly convex curve, and the SOC-OCV characteristics of unauthorized battery module 41 not described in the catalog but mounted in the vehicle type shows a downwardly convex curve.

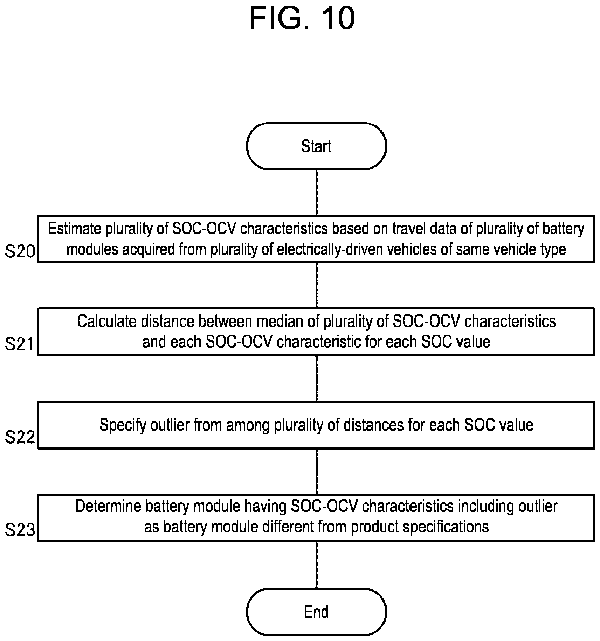

Fig. 10 is a flowchart illustrating the flow of the first processing example for arithmetic system 1 to detect whether or not battery module 41 different from catalog specifications by is mounted. Estimator 113 estimates the SOC-OCV characteristics of the plurality of battery modules 41 mounted in the vehicle type based on the travel data of the plurality of battery modules 41 acquired from the plurality of electrically-driven vehicles 3 of the same vehicle type (S20). Detector 114 calculates the distance between the median of the plurality of SOC-OCV characteristics and each SOC-OCV characteristic for each SOC value (S21). Detector 114 specifies an outlier from among the plurality of distances for each SOC value (S22). Detector 114 determines that electrically-driven vehicle 3 that has transmitted the SOC-OCV characteristics including the outlier is electrically-driven vehicle 3 on which battery module 41 different from the product specifications not described in the catalog is mounted (S23).

In the above description, the outlier of the distance from the median is searched in the entire SOC range (0 to 100%). In this respect, the SOC range where the outlier of the distance from the median is searched may be narrowed to a predetermined SOC range. For example, an outlier may be searched in a range of 40 to 70%. Depending on the type of battery, there is a tendency in the SOC range where the OCV difference increases. For example, in the case of a ternary lithium ion battery, the OCV difference tends to increase at the central portion of the SOC range, and the OCV difference tends to decrease at both ends of the SOC range.

The SOC range where the OCV difference is likely to occur may be learned for each vehicle type. As the number of samples increases, the tendency of the SOC range where the OCV difference is likely to occur can be grasped, and the calculation amount can be reduced by narrowing, to the SOC range, the range where the outlier is searched.

In order to reduce the calculation amount the most, it is effective a method of detecting whether or not battery module 41 different from the catalog specifications is mounted based on the relationship between the SOC and the OCV at one point of the plurality of battery modules 41 acquired from the plurality of electrically-driven vehicles 3 of the same vehicle type.

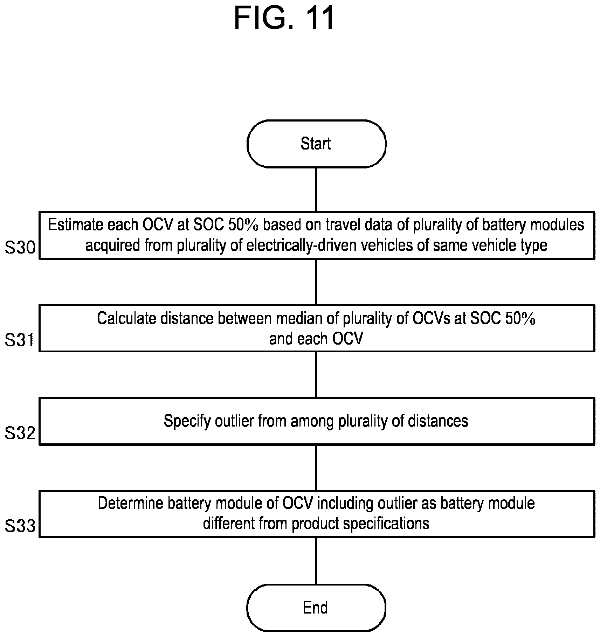

Fig. 11 is a flowchart illustrating the flow of the second processing example for arithmetic system 1 to detect whether or not battery module 41 different from catalog specifications by is mounted. Estimator 113 specifies the SOC and the OCV when the SOC is a specific value (for example, 50%) of the plurality of battery modules 41 mounted in the vehicle type based on the travel data of the plurality of battery modules 41 acquired from the plurality of electrically-driven vehicles 3 of the same vehicle type (S30). Detector 114 calculates the distance between the median of the plurality of OCVs when the SOC is a specific value and each OCV (S31). Detector 114 specifies an outlier from among the plurality of distances (S32). Detector 114 determines that electrically-driven vehicle 3 that has transmitted the OCV including the outlier is electrically-driven vehicle 3 on which battery module 41 different from the product specifications is mounted (S33).

In the second processing example, it is possible to omit the processing in which the estimator 113 generates an approximate curve based on sample data of a plurality of points and estimates the SOC-OCV characteristics for each battery module 41. If it has been possible to acquire the value of the OCV when the SOC is a specific value for each battery module 41, it is possible to detect electrically-driven vehicle 3 on which battery module 41 different from the catalog specifications is mounted.

In the second processing example, the calculation amount can be greatly reduced as compared with the first processing example, and the processing speed can be increased. However, the determination accuracy may decrease. Therefore, in the third processing example, an angle is added to the determination criterion other than the distance. In order to add the angle to the determination criterion, it is necessary to use the relationship between the SOC and the OCV at a plurality of points for each battery module 41. Hereinafter, a method of detecting whether or not battery module 41 different from the catalog specifications is mounted using three points indicating the relationship between the SOC and the OCV will be described.

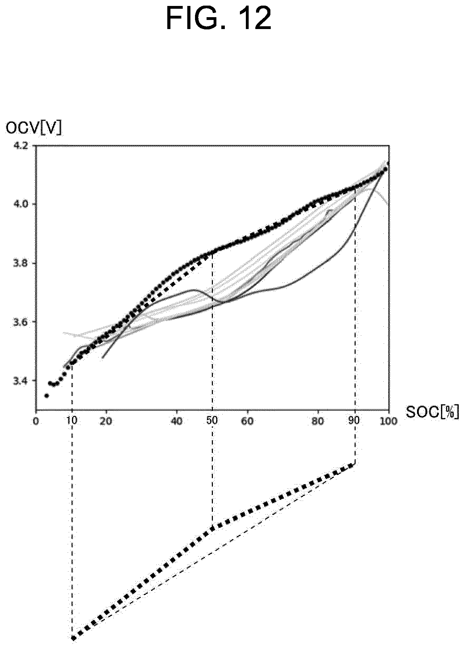

Fig. 12 is a view illustrating the shape of a line connecting three points of the median. In Fig. 12, the OCVs at three points when the SOCs are 10%, 50%, and 90% are connected. The three points at which the OCV is extracted are not limited to these numerical values, but it is preferable to extract one point from each of a low SOC range, a middle SOC range, and a high SOC range so that the entire shape can be easily grasped.

Although the SOC-OCV characteristics of the plurality of battery modules 41 are illustrated in Fig. 12, the third processing example can be performed as long as three points indicating the relationship between the SOC and the OCV are plotted for each battery module 41.

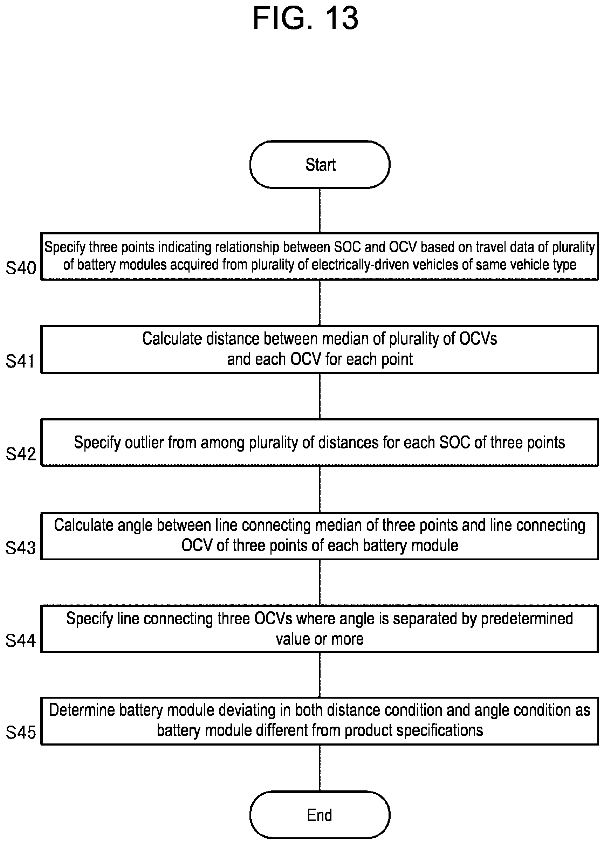

Fig. 13 is a flowchart illustrating the flow of the third processing example for arithmetic system 1 to detect whether or not battery module 41 different from catalog specifications by is mounted. Estimator 113 specifies three points indicating the relationship between the SOC and the OCV for each of the plurality of battery modules 41 mounted in the vehicle type based on the travel data of the plurality of battery modules 41 acquired from the plurality of electrically-driven vehicles 3 of the same vehicle type (S40). The distance between the median of the plurality of OCVs and each OCV is calculated for each of the three SOCs (S41). Detector 114 specifies an outlier from among the plurality of distances for each of the three SOCs (S42).

Detector 114 calculates each angle between a line connecting the median of the OCVs at the three points and a line connecting the OCVs at the three points of the respective battery modules 41 (S43). Detector 114 specifies the line connecting the OCVs at the three points whose angle is separated by equal to or greater than a predetermined value (S44). For example, in a case where at least one of the angle difference on the low SOC side from the line connecting the median of the OCVs at the three points and the angle difference on the high SOC side from the line connecting the median of the OCVs at the three points is equal to or greater than 10°, detector 114 determines that the line connecting the median of the OCVs at the three points and the line connecting the OCVs at the three points of battery module 41 that is the target is a line of a group having a different attribute.

Detector 114 determines that electrically-driven vehicle 3 that has transmitted the SOCs and the OCVs at three points deviated in both the distance condition and the angle condition is electrically-driven vehicle 3 on which battery module 41 different from the product specifications is mounted (S45).

Detector 114 may narrow the sample for which the angle comparison is performed to data including an outlier at the distance from the median. That is, detector 114 determines, without comparing the angles, the data not including the outlier in the distance to the median as the data of normal battery module 41 described in the catalog.

A threshold for specifying an outlier in the distance to the median may be loosely set. At that time, detector 114 may narrow the sample for which the angle comparison is performed to some of the data close to the threshold among data exceeding the threshold. Detector 114 unconditionally determines the remaining data far from the threshold as battery module 41 different from the product specifications.

In step S44, whether or not the attribute is different is determined depending on whether or not the angle difference is equal to or greater than a predetermined value, but whether or not the attribute is different may be determined depending on whether or not the line connecting three points is upwardly convex or downwardly convex. In the example illustrated in Fig. 12, since the line connecting the median of the OCVs at the three points is upwardly convex, detector 114 determines that the data is of normal battery module 41 if the line connecting the OCVs at the target three points is upwardly convex, and determines that the data is of battery module 41 different from the product specifications if the line connecting the OCVs at the three points of interest is downwardly convex.

In the examples illustrated in Figs. 12 and 13, an example of detecting whether or not battery module 41 different from the catalog specifications is mounted using the three points indicating the relationship between the SOC and the OCV has been described. In this respect, whether or not battery module 41 different from the catalog specifications is mounted may be detected using two points indicating the relationship between the SOC and the OCV. In this case, it is preferable to extract the two points where the OCV is extracted, as one point from each of the low SOC range and the middle SOC range, or one point from each of the middle SOC range and the high SOC range.

According to the present exemplary embodiment as described above, the data of each battery module 41 is collected from the plurality of electrically-driven vehicles 3 of the same vehicle type, and the collected data is subjected to cluster analysis by statistical processing, whereby electrically-driven vehicle 3 on which battery module 41 different from the catalog specifications is mounted can be easily detected. Detection can be performed regardless of the battery manufacturer and the battery type.

In the present exemplary embodiment, it is sufficient to have travel data of electrically-driven vehicle 3, and a special inspection device is unnecessary. It is also not necessary to add a new function to management unit 42 of battery system 40 of each electrically-driven vehicle 3. It is also not necessary to acquire characteristics of various batteries in advance. Therefore, it is possible to reduce financial and time costs for construction and operation of the system. For example, a maintenance time for adding battery characteristics is also unnecessary.

The present disclosure has been described above according to the exemplary embodiment. It will be understood by the person of ordinary skill in the art that the exemplary embodiment is merely an example, various modified examples in combinations of configuration elements and processing processes of the exemplary embodiments are possible, and such modified examples also fall within the scope of the present disclosure.

In the above-described exemplary embodiment, whether or not battery module 41 different from the catalog specifications is mounted is detected based the relationship between the SOC and the OCV of at least one point for each battery module 41. In this respect, it is also possible to detect whether or not battery module 41 different from the catalog specifications is mounted based on the relationship between the SOC and the internal resistance of at least one point for each battery module 41. The internal resistance also has dependence on the SOC. The relationship between the SOC and the internal resistance varies depending on the type of battery, but in general, the internal resistance tends to become high at both ends of the SOC range.

Internal resistance R can be calculated by the following (Equation 4) and the following (Equation 5).

$$R = (CCVd - OCVd)/Id \dots \quad \text{(Equation 4)}$$

$$R = (CCVc - OCVc)/Ic \dots \quad \text{(Equation 5)}$$

Closed circuit voltage (CCV) d is voltage at the time of discharge, CCVc is voltage at the time of charge, Id is discharge current, and Ic is charge current.

When the internal resistance is used instead of OCV, data other than the period in which battery module 41 is regarded to be in a resting state can also be used. For example, internal resistance R can be estimated by substituting, into the above (Equation 4), the voltage measured during traveling as CCVd, the current as Id, and the voltage measured immediately before the start of traveling as OCVd.

The above exemplary embodiment assumes an example of detecting whether or not battery module 41 different from the catalog specifications is mounted on four-wheeled electrically-driven vehicle 3. In this respect, electrically-driven vehicle 3 may be a two-wheeled electric motorcycle (electric scooter) or an electric bicycle. Electrically-driven vehicle 3 also includes low-speed electrically-driven vehicle 3 such as a golf cart and a land car used in a shopping mall or an entertainment facility.

Products on which battery module 41 is mounted are not limited to electrically-driven vehicles 3. For example, electric moving bodies such as electric ships, railway vehicles, and multicopters (drones) are also included. Products on which battery module 41 is mounted also include stationary power storage systems and consumer electronic equipment (smartphones, laptop PCs, and the like). In either case, by collecting the operation data of battery module 41 for each identical product, it is possible to detect whether or not each individual is mounted with battery module 41 different from the product specifications.

REFERENCE MARKS IN THE DRAWINGS

1: arithmetic system
2: business operator system
E1-En: cell
T1, T2: temperature sensor
RY1, RY2: relay
3: electrically-driven vehicle
4: charger
5: network
11: processor
111: data acquisition unit
112: extractor
113: estimator
114: detector
12: storage unit
121: travel data holding unit
122: SOC-OCV characteristic holding unit
21: processor
22: storage unit
221: travel data holding unit
222: driver data holding unit
23: display
24: operation unit
30: vehicle controller
34: motor
35: inverter
36: wireless communication unit
36a: antenna
38: charging cable
40: battery system
41: battery module
42: management unit
43: voltage measurement unit
44: temperature measurement unit
45: current measurement unit
46: battery controller
46a: SOC-OCV map

**Claims**

1. An arithmetic system comprising:

a data acquisition unit that acquires operation data items from electrically driven vehicles of a certain electrically driven vehicle type via a network, the operation data items each indicating at least a voltage and a state of charge of a battery used in a corresponding one of the electrically driven vehicles, and
a detector that performs statistical processing on the operation data items acquired by the data acquisition unit to detect, from among the electrically driven vehicles, an electrically driven vehicle using a battery of a battery type that is different from a battery type in conformity with specifications of the electrically driven vehicle type, wherein the data acquisition unit acquires, from the corresponding one of the electrically driven vehicles, operation data items at least including a voltage, a current, and a state of charge at a plurality of times measured on the corresponding one of the electrically driven vehicles, and
the arithmetic system further includes

an extractor that extracts, as sample data, a set of state of charge and voltage in a period in which the battery is regarded to be in a resting state, the set being specified based on the current, from a set of state of charge and voltage at a plurality of times included in each of the operation data items, and

an estimator that estimates state of charge-open circuit voltage characteristics of a plurality of batteries each used in the electrically driven vehicles based on extracted sample data, and wherein the detector detects, from among the electrically driven vehicles, an electrically driven vehicle using a battery of a battery type that is different from a battery type in conformity with specifications of the electrically driven vehicle type based on a deviation degree from a representative value of state of charge-open circuit voltage characteristics of the plurality of batteries.

2. The arithmetic system according to Claim 1, wherein the detector detects, from among the electrically driven vehicle, an electrically driven vehicle using a battery of a battery type that is different from a battery type in conformity with specifications of the electrically driven vehicle type using data in a predetermined state of charge range in state of charge-open circuit voltage characteristics of the plurality of batteries.

3. The arithmetic system according to Claim 1, wherein

the data acquisition unit acquires, from the corresponding one of the electrically driven vehicles, operation data items at least including a voltage, a current, and a state of charge at least at one time measured the corresponding one of the electrically driven vehicles,
the arithmetic system further includes

an extractor that extracts, as sample data, a set of state of charge and voltage in a period in which the battery is regarded to be in a resting state, the set being specified based on the current, from at least one set of state of charge and voltage included in each of the operation data items, and
a specification unit that specifies, based on the sample data extracted, a relationship between a state of charge of a specific value at least at one point and an open circuit voltage, of a plurality of batteries each used in the electrically driven vehicles, and
the detector detects, from among the electrically driven evehicles, an electrically driven vehicle using a battery of a battery type that is different from a battery type in conformity with specifications of the electrically driven vehicle type based on the relationship between the state of charge of the specific value of at least one point and the open circuit voltage, of the plurality of batteries.

4. The arithmetic system according to Claim 3, wherein the detector detects, from among the electrically driven evehicles, an electrically driven vehicle using a battery of a battery type that is different from a battery type in conformity with specifications of the electrically driven vehicle type, based on a deviation degree of a distance between each of representative values of a plurality of points indicating a relationship between a state of charge and an open circuit voltage of the plurality of batteries and each value of a plurality of points indicating a relationship between a state of charge and an open circuit voltage of each of the plurality of batteries, and a separation degree of an angle between a line connecting the representative values of the plurality of points and a line connecting the plurality of points indicating the relationship between the state of charge and the open circuit voltage of each of the plurality of batteries.

5. The arithmetic system according to Claim 3, wherein the detector detects, from among the electrically driven vehicles, an electrically driven vehicle using a battery of a battery type that is different from a battery type in conformity with specifications of the electrically driven vehicle type, based on a deviation degree of a distance between each value of a plurality of points indicating a relationship between a state of charge and an open circuit voltage of specifications of the electrically driven vehicle and each value of a plurality of points indicating a relationship between a state of charge and an open circuit voltage of each of the plurality of batteries, and a separation degree of an angle between a line connecting each value of the plurality of points indicating the relationship between the state of charge and the open circuit voltage of specifications of the electrically driven vehicle and a line connecting the plurality of points indicating the relationship between the state of charge and the open circuit voltage of each of the plurality of batteries.

6. The arithmetic system according to Claim 1, wherein

the data acquisition unit acquires, from the corresponding one of the electrically driven vehicles, operation data items at least including a voltage, a current, and a state of charge at least at one time measured on the corresponding one of the electrically driven vehicles,
the arithmetic system further includes a specification unit that specifies, based on the operation data items, a relationship between a state of charge of a specific value at least at one point and an internal resistance, of a plurality of batteries each used in the electrically driven vehicles, and

the detector detects, from among the electrically drive vehicles, an electrically driven vehicle using a battery of a battery type that is different from a battery type in conformity with specifications of the electrically driven vehicle type based on the relationship between the state of charge of the specific value of at least one point and the internal resistance, of the plurality of batteries.

7. A battery inspection method comprising:

acquiring operation data items from electrically driven vehicles of a certain electrically driven vehicle type via a network, the operation data items each indicating at least a voltage and a state of charge of a battery used in a corresponding one of the electrically driven vehicles, and

statistically processing on the operation data items acquired by the data acquisition unit to detect, from among the electrically driven vehicles, an electrically driven vehicle using a battery of a battery type that is different from a battery type in conformity with specifications of the electrically driven vehicle type,

wherein the operation data items acquired, from the corresponding one of the electrically driven vehicles, at least include a voltage, a current, and a state of charge at a plurality of times measured on the corresponding one of the electrically driven vehicles, and

the battery inspection method further includes

extracting, as sample data, a set of state of charge and voltage in a period in which the battery is regarded to be in a resting state, the set being specified based on the current, from a set of state of charge and voltage at a plurality of times included in each of the operation data items, and

estimating state of charge-open circuit voltage characteristics of a plurality of batteries each used in the electrically driven vehicles based on extracted sample data, and

further detecting, from among the electrically driven vehicles, an electrically driven vehicle using a battery of a battery type that is different from a battery type in conformity with specifications of the electrically driven vehicle type based on a deviation degree from a representative value of state of charge-open circuit voltage characteristics of the plurality of batteries.

8. A non-transitory computer-readable medium storing a battery inspection program that causes a computer to execute:

processing of acquiring operation data items from electrically driven vehicles of a certain electrically driven vehicle type via a network, the operation data items each indicating at least a voltage and a state of charge of a battery used in a corresponding one of the electrically driven vehicles, and

processing of statistically processing on the operation data items acquired by the data acquisition unit to detect, from among the electrically driven vehicles, an electrically driven vehicle using a battery of a battery type that is different from a battery type in conformity with specifications of the electrically driven vehicle type,

wherein the operation data items acquired, from the corresponding one of the electrically driven vehicles, at least include a voltage, a current, and a state of charge at a plurality of times measured on the corresponding one of the electrically driven vehicles, and

the battery inspection method further includes

extracting, as sample data, a set of state of charge and voltage in a period in which the battery is regarded to be in a resting state, the set being specified based on the current, from a set of state of charge and voltage at a plurality of times included in each of the operation data items, and

estimating state of charge-open circuit voltage characteristics of a plurality of batteries each used in the electrically driven vehicles based on extracted sample data, and

further detecting, from among the electrically driven vehicles, an electrically driven vehicle using a battery of a battery type that is different from a battery type in conformity with specifications of the electrically driven vehicle type based on a deviation degree from a representative value of state of charge-open circuit voltage characteristics of the plurality of batteries.

**Patentansprüche**

1. Arithmetisches System, umfassend:

eine Datenerfassungseinheit, die Betriebsdatenelemente von elektrisch angetriebenen Fahrzeugen von einem bestimmten elektrisch angetriebenen Fahrzeugtyp über ein Netzwerk erfasst, wobei die Betriebsdatenelemente jeweils mindestens eine Spannung und einen Ladezustand einer Batterie angeben, die in einem entsprechenden der elektrisch angetriebenen Fahrzeuge verwendet wird, und

einen Detektor, der statistische Verarbeitung auf den von der Datenerfassungseinheit erfassten Betriebsdatenelementen durchführt, um unter den elektrisch angetriebenen Fahrzeugen ein elektrisch angetriebenes Fahrzeug zu detektieren, das eine Batterie eines Batterietyps verwendet, der sich von einem Batterietyp in Übereinstimmung mit Spezifikationen des elektrisch angetriebenen Fahrzeugtyps unterscheidet, wobei die Datenerfassungseinheit von dem entsprechenden der elektrisch angetriebenen Fahrzeuge Betriebsdatenelemente erfasst, die mindestens eine Spannung, einen Strom und einen Ladezustand an einer Vielzahl von Zeitpunkten umfassen, die bei dem entsprechenden von den elektrisch angetriebenen Fahrzeugen gemessen werden, und das arithmetische System ferner umfasst:

einen Extraktor, der als Messdaten eine Menge von Ladezustand und Spannung in einer Periode, in der die Batterie als sich in einem Ruhezustand befindlich betrachtet wird, wobei die Menge basierend auf dem Strom spezifiziert ist, von einer Menge von Ladezustand und Spannung an einer Vielzahl von Zeitpunkten extrahiert, die in jedem der Betriebsdatenelemente enthalten ist, und

eine Schätzungseinrichtung, die Ladezustand-Leerlaufspannung-Kennlinien einer Vielzahl von Batterien, die jeweils in den elektrisch angetriebenen Fahrzeugen verwendet werden, basierend auf extrahierten Messdaten schätzt, und wobei der Detektor unter den elektrisch angetriebenen Fahrzeugen ein elektrisch angetriebenes Fahrzeug, das eine Batterie eines Batterietyps verwendet, der sich von einem Batterietyp in Übereinstimmung mit Spezifikationen des elektrisch angetriebenen Fahrzeugtyps unterscheidet, basierend auf einem Abweichungsgrad von einem repräsentativen Wert von Ladezustand-Leerlaufspannung-Kennlinien der Vielzahl von Batterien detektiert.

2. Arithmetisches System nach Anspruch 1, wobei der Detektor unter den elektrisch angetriebenen Fahrzeugen ein elektrisch angetriebenes Fahrzeug, das eine Batterie eines Batterietyps verwendet, der sich von einem Batterietyp in Übereinstimmung mit Spezifikationen des elektrisch angetriebenen Fahrzeugtyps unterscheidet, unter Verwendung von Daten in einem vorbestimmten Ladezustandsbereich in Ladezustand-Leerlaufspannung-Kennlinien der Vielzahl von Batterien detektiert.

3. Arithmetisches System nach Anspruch 1, wobei

die Datenerfassungseinheit von dem entsprechenden der elektrisch angetriebenen Fahrzeuge Betriebsdatenelemente erfasst, die mindestens eine Spannung, einen Strom und einen Ladezustand an mindestens einem Zeitpunkt umfassen, die bei dem entsprechenden der elektrisch angetriebenen Fahrzeuge gemessen werden, wobei das arithmetische System ferner umfasst:

einen Extraktor, der als Messdaten eine Menge von Ladezustand und Spannung in einer Periode, in der die Batterie als sich in einem Ruhezustand befindlich betrachtet wird, wobei die Menge basierend auf dem Strom spezifiziert ist, von mindestens einer Menge von Ladezustand und Spannung extrahiert, die in jedem der Betriebsdatenelementen enthalten ist, und

eine Spezifikationseinheit, die basierend auf den extrahierten Messdaten eine Beziehung zwischen einem Ladezustand mit einem spezifischen Wert an mindestens einem Punkt und einer Leerlaufspannung einer Vielzahl von Batterien spezifiziert, die jeweils in den elektrisch angetriebenen Fahrzeugen verwendet werden, und

der Detektor unter den elektrisch angetriebenen Fahrzeugen ein elektrisch angetriebenes Fahrzeug, das eine Batterie eines Batterietyps verwendet, der sich von einem Batterietyp in Übereinstimmung mit Spezifikationen des elektrisch angetriebenen Fahrzeugtyps unterscheidet, basierend auf der Beziehung zwischen dem Ladezustand mit dem spezifischen Wert von mindestens einem Punkt und der Leerlaufspannung der Vielzahl von Batterien detektiert.

4. Arithmetisches System nach Anspruch 3, wobei der Detektor unter den elektrisch angetriebenen Fahrzeugen ein elektrisch angetriebenes Fahrzeug, das eine Batterie eines Batterietyps verwendet, der sich von einem Batterietyp in Übereinstimmung mit Spezifikationen des elektrisch angetriebenen Fahrzeugtyps unterscheidet, basierend auf einem Abweichungsgrad eines Abstands zwischen jedem von repräsentativen Werten einer Vielzahl von Punkten, die eine Beziehung zwischen einem Ladezustand und einer Leerlaufspannung der Vielzahl von Batterien angeben, und jedem Wert einer Vielzahl von Punkten, die eine Beziehung zwischen einem Ladezustand und einer Leerlaufspannung von jeder der Vielzahl von Batterien angeben, und einem Trennungsgrad eines Winkels zwischen einer Linie, welche die repräsentativen Werte der Vielzahl von Punkten verbindet, und einer Linie, welche die Vielzahl von Punkten, welche die Beziehung zwischen dem Ladezustand und der Leerlaufspannung jeder der Vielzahl von Batterien verbindet, detektiert.

5. Arithmetisches System nach Anspruch 3, wobei der Detektor unter den elektrisch angetriebenen Fahrzeugen ein elektrisch angetriebenes Fahrzeug, das eine Batterie eines Batterietyps verwendet, der sich von einem Batterietyp in Übereinstimmung mit Spezifikationen des elektrisch angetriebenen Fahrzeugtyps unterscheidet, basierend auf einem Abweichungsgrad eines Abstands zwischen jedem Wert einer Vielzahl von Punkten, die eine Beziehung zwischen einem Ladezustand und einer Leerlaufspannung von Spezifikationen des elektrisch angetriebenen Fahrzeug angeben, und jedem Wert einer Vielzahl von Punkten, die eine Beziehung zwischen einem Ladezustand und einer Leerlaufspannung von jeder der Vielzahl von Batterien angeben, und einem Trennungsgrad eines Winkels zwischen einer Linie, die jeden Wert der Vielzahl von Punkten verbindet, welche die Beziehung zwischen dem Ladezustand und der Leerlaufspannung von Spezifikationen des elektrisch angetriebenen Fahrzeugs angeben, und einer Linie, welche die Vielzahl von Punkten verbindet, welche die Beziehung zwischen dem Ladezustand und der Leerlaufspannung jeder der Vielzahl von Batterien angeben, detektiert.

6. Arithmetisches System nach Anspruch 1, wobei

die Datenerfassungseinheit von dem entsprechenden der elektrisch angetriebenen Fahrzeuge Betriebsdatenelemente erfasst, die mindestens eine Spannung, einen Strom und einen Ladezustand an mindestens einem Zeitpunkt umfassen, die bei dem entsprechenden der elektrisch angetriebenen Fahrzeuge gemessen werden, wobei das arithmetische System ferner eine Spezifikationseinheit umfasst, die basierend auf den Betriebsdatenelementen eine Beziehung zwischen einem Ladezustand mit einem spezifischen Wert an mindestens einem Punkt und einem Innenwiderstand einer Vielzahl von Batterien spezifiziert, die jeweils in den elektrisch angetriebenen Fahrzeugen verwendet werden, und
der Detektor unter den elektrisch angetriebenen Fahrzeugen ein elektrisch angetriebenes Fahrzeug, das eine Batterie eines Batterietyps verwendet, der sich von einem Batterietyp in Übereinstimmung mit Spezifikationen des elektrisch angetriebenen Fahrzeugtyps unterscheidet, basierend auf der Beziehung zwischen dem Ladezustand mit dem spezifischen Wert von mindestens einem Punkt und dem Innenwiderstand der Vielzahl von Batterien detektiert.

7. Batterieprüfverfahren, umfassend:

Erfassen von Betriebsdatenelementen von elektrisch angetriebenen Fahrzeugen eines bestimmten elektrisch angetriebenen Fahrzeugtyps über ein Netzwerk, wobei die Betriebsdatenelemente jeweils mindestens eine Spannung und einen Ladezustand einer Batterie angeben, die in einem entsprechenden der elektrisch angetriebenen Fahrzeuge verwendet wird, und
statistisches Verarbeiten auf den von der Datenerfassungseinheit erfassten Betriebsdatenelementen, um unter den elektrisch angetriebenen Fahrzeugen ein elektrisch angetriebenes Fahrzeug zu detektieren, das eine Batterie eines Batterietyps verwendet, der sich von einem Batterietyp in Übereinstimmung mit Spezifikationen des elektrisch angetriebenen Fahrzeugtyps unterscheidet,
wobei die von dem entsprechenden der elektrisch angetriebenen Fahrzeuge erfassten Betriebsdatenelemente mindestens eine Spannung, einen Strom und einen Ladezustand an einer Vielzahl von Zeitpunkten umfassen, die bei dem entsprechenden der elektrisch angetriebenen Fahrzeuge gemessen werden, und
das Batterieprüfverfahren ferner umfasst:

Extrahieren, als Messdaten, einer Menge von Ladezustand und Spannung in einer Periode, in der die Batterie als sich in einem Ruhezustand befindlich betrachtet wird, wobei die Menge basierend auf dem Strom von einer Menge von Ladezustand und Spannung an einer Vielzahl von Zeitpunkten spezifiziert wird, die in jedem der Betriebsdatenelemente enthalten ist, und
Schätzen eines Zustands von Ladezustand-Leerlaufspannung-Kennlinien einer Vielzahl von Batterien, die jeweils in den elektrisch angetriebenen Fahrzeugen verwendet werden, basierend auf extrahierten Messdaten, und
ferner Detektieren, unter den elektrisch angetriebenen Fahrzeugen, eines elektrisch angetriebenen Fahrzeugs, das eine Batterie eines Batterietyps verwendet, der sich von einem Batterietyp in Übereinstimmung mit Spezifikationen des elektrisch angetriebenen Fahrzeugtyps unterscheidet, basierend auf einem Abweichungsgrad von einem repräsentativen Wert von Ladezustand-Leerlaufspannung-Kennlinien der Vielzahl von Batterien.

8. Nichtflüchtiger maschinenlesbarer Datenträger, der ein Batterieprüfprogramm speichert, das einen Computer veranlasst, Folgendes auszuführen:

Verarbeiten des Erfassens von Betriebsdatenelementen von elektrisch angetriebenen Fahrzeugen eines bestimmten elektrisch angetriebenen Fahrzeugtyps über ein Netzwerk, wobei die Betriebsdatenelemente jeweils mindestens eine Spannung und einen Ladezustand einer Batterie angeben, die in einem entsprechenden der elektrisch angetriebenen Fahrzeuge verwendet wird, und
Verarbeiten von statistischer Verarbeitung auf den von der Datenerfassungseinheit erfassten Betriebsdatenelementen, um unter den elektrisch angetriebenen Fahrzeugen ein elektrisch angetriebenes Fahrzeug zu detektieren, das eine Batterie eines Batterietyps verwendet, der sich von einem Batterietyp in Übereinstimmung mit Spezifikationen des elektrisch angetriebenen Fahrzeugtyps unterscheidet,
wobei die von dem entsprechenden der elektrisch angetriebenen Fahrzeuge erfassten Betriebsdatenelemente mindestens eine Spannung, einen Strom und einen Ladezustand an einer Vielzahl von Zeitpunkten umfassen, die bei dem entsprechenden der elektrisch angetriebenen Fahrzeuge gemessen werden, und
das Batterieprüfverfahren ferner umfasst:

Extrahieren, als Messdaten, einer Menge von Ladezustand und Spannung in einer Periode, in der die Batterie als sich in einem Ruhezustand befindlich betrachtet wird, wobei die Menge basierend auf dem Strom von einer Menge von Ladezustand und Spannung an einer Vielzahl von Zeitpunkten spezifiziert wird, die in jedem der Betriebsdatenelemente enthalten sind, und
Schätzen von Ladezustand-Leerlaufspannung-Kennlinien einer Vielzahl von Batterien, die jeweils in den elektrisch angetriebenen Fahrzeugen verwendet werden, basierend auf den extrahierten Messdaten, und ferner Detektieren, unter den elektrisch angetriebenen Fahrzeugen, eines elektrisch angetriebenen Fahrzeugs, das eine Batterie eines Batterietyps verwendet, der sich von einem Batterietyp in Übereinstimmung mit Spezifikationen des elektrisch angetriebenen Fahrzeugtyps unterscheiden, basierend auf einem Abweichungsgrad von einem repräsentativen Wert von Ladezustand-Leerlaufspannung-Kennlinien der Vielzahl von Batterien.

## Revendications

1. Système arithmétique comprenant :

une unité d'acquisition de données qui acquiert des éléments de données de fonctionnement à partir de véhicules à propulsion électrique d'un certain type de véhicule à propulsion électrique via un réseau, les éléments de données de fonctionnement indiquant chacun au moins une tension et un état de charge d'une batterie utilisée dans un véhicule correspondant des véhicules à propulsion électrique, et
un détecteur qui effectue un traitement statistique sur les éléments de données de fonctionnement acquis par l'unité d'acquisition de données, pour détecter parmi les véhicules à propulsion électrique un véhicule à propulsion électrique utilisant une batterie d'un type de batterie qui est différent du type de batterie conforme aux spécifications du type de véhicule à propulsion électrique, dans lequel
l'unité d'acquisition de données acquiert, à partir du véhicule correspondant des véhicules à propulsion électrique, des éléments de données de fonctionnement comportant au moins une tension, un courant et un état de charge à une pluralité de temps mesurés sur le véhicule correspondant des véhicules à propulsion électrique, et
le système arithmétique comporte en outre
un extracteur qui extrait, en tant que données d'échantillonnage, un ensemble d'état de charge et de tension dans une période au cours de laquelle la batterie est considérée comme étant dans un état de repos, l'ensemble étant spécifié sur la base du courant à partir d'un ensemble d'état de charge et de tension à une pluralité de temps inclus dans chacun des éléments de données de fonctionnement, et
un estimateur qui estime des caractéristiques d'état de charge-de tension de circuit ouvert d'une pluralité de batteries utilisées chacune dans les véhicules à propulsion électrique, sur la base d'un échantillon de données extraites, et dans lequel le détecteur détecte, parmi les véhicules à propulsion électrique, un véhicule à propulsion électrique utilisant une batterie d'un type de batterie qui est différent du type de batterie conforme aux spécifications du type de véhicule à propulsion électrique, sur la base du degré d'écart par rapport à une valeur représentative des caractéristiques d'état de charge-de tension de circuit ouvert de la pluralité de batteries.

2. Système arithmétique selon la revendication 1, dans lequel le détecteur détecte, parmi les véhicules à propulsion électrique, un véhicule à propulsion électrique utilisant une batterie d'un type de batterie qui est différent du type de batterie conforme aux spécifications du type de véhicule à propulsion électrique, en utilisant les données d'une plage d'états de charge prédéterminée dans les caractéristiques d'état de charge-de tension de circuit ouvert de la pluralité de batteries.

**3.** Système arithmétique selon la revendication 1, dans lequel

l'unité d'acquisition de données acquiert, à partir du véhicule correspondant des véhicules à propulsion électrique, des éléments de données de fonctionnement comportant au moins une tension, un courant et un état de charge, au moins à un temps mesuré sur le véhicule correspondant des véhicules à propulsion électrique, le système arithmétique comporte en outre
un extracteur qui extrait, en tant que données d'échantillonnage, un ensemble d'état de charge et de tension dans une période au cours de laquelle la batterie est considérée comme étant dans un état de repos, l'ensemble étant spécifié sur la base du courant à partir d'au moins un ensemble d'état de charge et de tension inclus dans chacun des éléments de données de fonctionnement, et
une unité de spécification qui spécifie, sur la base des données d'échantillon extraites, une relation entre un état de charge d'une valeur spécifique en au moins un point et une tension de circuit ouvert d'une pluralité de batteries utilisées chacune dans les véhicules à propulsion électrique, et
le détecteur détecte, parmi les véhicules à propulsion électrique, un véhicule à propulsion électrique utilisant une batterie d'un type de batterie qui est différent du type de batterie conforme aux spécifications du type de véhicule à propulsion électrique, sur la base de la relation entre l'état de charge de la valeur spécifique d'au moins un point et de la tension de circuit ouvert de la pluralité de batteries.

**4.** Système arithmétique selon la revendication 3, dans lequel le détecteur détecte, parmi les véhicules à propulsion électrique, un véhicule à propulsion électrique utilisant une batterie d'un type de batterie qui est différent du type de batterie conforme aux spécifications du type de véhicule à propulsion électrique, sur la base d'un degré d'écart d'une distance entre chacune des valeurs représentatives d'une pluralité de points indiquant une relation entre un état de charge et une tension de circuit ouvert de la pluralité de batteries, et chaque valeur d'une pluralité de points indiquant une relation entre un état de charge et une tension de circuit ouvert de chacune de la pluralité de batteries, et d'un degré de séparation d'un angle entre une ligne connectant les valeurs représentatives de la pluralité de points et une ligne connectant la pluralité de points indiquant la relation entre l'état de charge et la tension de circuit ouvert de chacune de la pluralité de batteries.

**5.** Système arithmétique selon la revendication 3, dans lequel le détecteur détecte, parmi les véhicules à propulsion électrique, un véhicule à propulsion électrique utilisant une batterie d'un type de batterie qui est différent du type de batterie conforme aux spécifications du type de véhicule à propulsion électrique, sur la base d'un degré d'écart d'une distance entre chaque valeur d'une pluralité de points indiquant une relation entre un état de charge et une tension de circuit ouvert de spécifications du véhicule à propulsion électrique et chaque valeur d'une pluralité de points indiquant une relation entre un état de charge et une tension de circuit ouvert de chacune de la pluralité de batteries, et d'un degré de séparation d'un angle entre une ligne connectant chaque valeur de la pluralité de points indiquant la relation entre l'état de charge et la tension de circuit ouvert de spécifications du véhicule à propulsion électrique et une ligne connectant la pluralité de points indiquant la relation entre l'état de charge et la tension de circuit ouvert de chacune de la pluralité de batteries.

**6.** Système arithmétique selon la revendication 1, dans lequel

l'unité d'acquisition de données acquiert, à partir du véhicule correspondant des véhicules à propulsion électrique, des éléments de données de fonctionnement comportant au moins une tension, un courant et un état de charge au moins à un temps mesuré sur le véhicule correspondant des véhicules à propulsion électrique, le système arithmétique comporte en outre une unité de spécification qui spécifie, sur la base des éléments de données de fonctionnement, une relation entre un état de charge d'une valeur spécifique en au moins un point et une résistance interne, d'une pluralité de batteries utilisées chacune dans les véhicules à propulsion électrique, et
le détecteur détecte, parmi les véhicules à propulsion électrique, un véhicule à propulsion électrique utilisant une batterie d'un type de batterie qui est différent du type de batterie conforme aux spécifications du type de véhicule à propulsion électrique, sur la base de la relation entre l'état de charge de la valeur spécifique d'au moins un point et la résistance interne de la pluralité de batteries.

**7.** Procédé d'inspection de batterie comprenant :

l'acquisition d'éléments de données de fonctionnement à partir de véhicules à propulsion électrique d'un certain type de véhicule à propulsion électrique via un réseau, les éléments de données de fonctionnement indiquant chacun au moins une tension et un état de charge d'une batterie utilisée dans un véhicule correspondant des véhicules à propulsion électrique, et

le traitement statistique sur les éléments de données de fonctionnement acquis par l'unité d'acquisition de données, pour détecter parmi les véhicules à propulsion électrique un véhicule à propulsion électrique utilisant une batterie **d'un** type de batterie qui est différent du type de batterie conforme aux spécifications du type de véhicule à propulsion électrique,

dans lequel les éléments de données de fonctionnement acquis à partir du véhicule correspondant des véhicules à propulsion électrique comportent au moins une tension, un courant et un état de charge à une pluralité de temps mesurés sur le véhicule correspondant des véhicules à propulsion électrique, et

le procédé d'inspection de batterie comporte en outre

l'extraction, en tant que données d'échantillonnage, d'un ensemble d'état de charge et de tension dans une période au cours de laquelle la batterie est considérée comme étant dans un état de repos, l'ensemble étant spécifié sur la base du courant à partir d'un ensemble d'état de charge et de tension à une pluralité de temps inclus dans chacun des éléments de données de fonctionnement, et

l'estimation de caractéristiques d'état de charge-de tension de circuit ouvert d'une pluralité de batteries utilisées chacune dans les véhicules à propulsion électrique sur la base d'un échantillon de données extraites, et

en outre la détection, parmi les véhicules à propulsion électrique, d'un véhicule à propulsion électrique utilisant une batterie d'un type de batterie qui est différent du type de batterie conforme aux spécifications du type de véhicule à propulsion électrique, sur la base du degré d'écart par rapport à une valeur représentative des caractéristiques d'état de charge-de tension de circuit ouvert de la pluralité de batteries.

8. Support non transitoire lisible par ordinateur stockant un programme d'inspection de batterie qui amène l'ordinateur à exécuter :

le traitement de l'acquisition d'éléments de données de fonctionnement à partir de véhicules à propulsion électrique d'un certain type de véhicule à propulsion électrique via un réseau, les éléments de données de fonctionnement indiquant chacun au moins une tension et un état de charge d'une batterie utilisée dans un véhicule correspondant des véhicules à propulsion électrique, et

le traitement du traitement statistique sur les éléments de données de fonctionnement acquis par l'unité d'acquisition de données, pour détecter parmi les véhicules à propulsion électrique un véhicule à propulsion électrique utilisant une batterie d'un type de batterie qui est différent du type de batterie conforme aux spécifications du type de véhicule à propulsion électrique,

dans lequel les éléments de données de fonctionnement acquis à partir du véhicule correspondant des véhicules à propulsion électrique comportent au moins une tension, un courant et un état de charge à une pluralité de temps mesurés sur le véhicule correspondant des véhicules à propulsion électrique, et

le procédé d'inspection de batterie comporte en outre

l'extraction, en tant que données d'échantillonnage, d'un ensemble d'état de charge et de tension dans une période au cours de laquelle la batterie est considérée comme étant dans un état de repos, l'ensemble étant spécifié sur la base du courant à partir d'un ensemble d'état de charge et de tension à une pluralité de temps inclus dans chacun des éléments de données de fonctionnement, et

l'estimation de caractéristiques d'état de charge-de tension de circuit ouvert d'une pluralité de batteries utilisées chacune dans les véhicules à propulsion électrique sur la base d'un échantillon de données extraites, et

la détection en outre, parmi les véhicules à propulsion électrique, d'un véhicule à propulsion électrique utilisant une batterie d'un type de batterie qui est différent du type de batterie conforme aux spécifications du type de véhicule à propulsion électrique, sur la base du degré d'écart par rapport à une valeur représentative des caractéristiques d'état de charge-de tension de circuit ouvert de la pluralité de batteries.

# FIG. 1

# FIG. 2

# FIG. 3

# FIG. 4

**Business operator system** (2)

- Display (23)
- Operation unit (24)
- Processor (21)
- Storage unit (22)
  - Travel data holding unit (221)
  - Driver data holding unit (222)

(5)

**Arithmetic system** (1)

- Processor (11)
  - Data acquisition unit (111)
  - Extractor (112)
  - Estimator (113)
  - Detector (114)
- Storage unit (12)
  - Travel data holding unit (121)
  - SOC-OCV characteristic holding unit (122)

# FIG. 5A

# FIG. 5B

# FIG. 6

Start

S10 | Acquire travel data (voltage, current, SOC, temperature) of electrically-driven vehicle

S11 | Extract set of SOC and voltage of period in which battery module is regarded to be in resting state

S12 | Estimate SOC-OCV characteristics from plurality of extracted sets of SOC and voltage

End

# FIG. 7

# FIG. 8

# FIG. 9

# FIG. 10

```
            ┌─────────────┐
            │    Start     │
            └─────────────┘
                   │
┌──────┬──────────────────────────────────────────────────────────────────────┐
│ S20  │ Estimate plurality of SOC-OCV characteristics based on travel data of  │
│      │ plurality of battery modules acquired from plurality of                │
│      │ electrically-driven vehicles of same vehicle type                      │
└──────┴──────────────────────────────────────────────────────────────────────┘
                   │
┌──────┬──────────────────────────────────────────────────────────────────────┐
│ S21  │ Calculate distance between median of plurality of SOC-OCV              │
│      │ characteristics and each SOC-OCV characteristic for each SOC value     │
└──────┴──────────────────────────────────────────────────────────────────────┘
                   │
┌──────┬──────────────────────────────────────────────────────────────────────┐
│ S22  │ Specify outlier from among plurality of distances for each SOC value   │
└──────┴──────────────────────────────────────────────────────────────────────┘
                   │
┌──────┬──────────────────────────────────────────────────────────────────────┐
│ S23  │ Determine battery module having SOC-OCV characteristics including      │
│      │ outlier as battery module different from product specifications        │
└──────┴──────────────────────────────────────────────────────────────────────┘
                   │
            ┌─────────────┐
            │     End      │
            └─────────────┘
```

# FIG. 11

```
                        ╭──────────────╮
                        │    Start      │
                        ╰──────────────╯
                               │
┌──────────────────────────────────────────────────────────────────────┐
│ Estimate each OCV at SOC 50% based on travel data of plurality of       │
│ battery modules acquired from plurality of electrically-driven vehicles  │
│ of same vehicle type                                                     │
└──────────────────────────────────────────────────────────────────────┘
  S30
                               │
┌──────────────────────────────────────────────────────────────────────┐
│ Calculate distance between median of plurality of OCVs at SOC 50%       │
│ and each OCV                                                             │
└──────────────────────────────────────────────────────────────────────┘
  S31
                               │
┌──────────────────────────────────────────────────────────────────────┐
│ Specify outlier from among plurality of distances                       │
└──────────────────────────────────────────────────────────────────────┘
  S32
                               │
┌──────────────────────────────────────────────────────────────────────┐
│ Determine battery module of OCV including outlier as battery module     │
│ different from product specifications                                    │
└──────────────────────────────────────────────────────────────────────┘
  S33
                               │
                        ╭──────────────╮
                        │     End       │
                        ╰──────────────╯
```

S30 Estimate each OCV at SOC 50% based on travel data of plurality of battery modules acquired from plurality of electrically-driven vehicles of same vehicle type

S31 Calculate distance between median of plurality of OCVs at SOC 50% and each OCV

S32 Specify outlier from among plurality of distances

S33 Determine battery module of OCV including outlier as battery module different from product specifications

# FIG. 12

**EP 4 181 265 B1**

# FIG. 13

```
                    ┌─────────────┐
                    │    Start     │
                    └──────┬───────┘
                           │
S40  ┌─────────────────────────────────────────────────────────────────────┐
     │ Specify three points indicating relationship between SOC and OCV      │
     │ based on travel data of plurality of battery modules acquired from     │
     │ plurality of electrically-driven vehicles of same vehicle type         │
     └─────────────────────────────────┬───────────────────────────────────┘
                                        │
S41  ┌─────────────────────────────────────────────────────────────────────┐
     │            Calculate distance between median of plurality of OCVs      │
     │                        and each OCV for each point                     │
     └─────────────────────────────────┬───────────────────────────────────┘
                                        │
S42  ┌─────────────────────────────────────────────────────────────────────┐
     │    Specify outlier from among plurality of distances for each SOC      │
     │                          of three points                               │
     └─────────────────────────────────┬───────────────────────────────────┘
                                        │
S43  ┌─────────────────────────────────────────────────────────────────────┐
     │ Calculate angle between line connecting median of three points and     │
     │     line connecting OCV of three points of each battery module         │
     └─────────────────────────────────┬───────────────────────────────────┘
                                        │
S44  ┌─────────────────────────────────────────────────────────────────────┐
     │ Specify line connecting three OCVs where angle is separated by          │
     │              predetermined value or more                                │
     └─────────────────────────────────┬───────────────────────────────────┘
                                        │
S45  ┌─────────────────────────────────────────────────────────────────────┐
     │ Determine battery module deviating in both distance condition and      │
     │ angle condition as battery module different from product specifications │
     └─────────────────────────────────┬───────────────────────────────────┘
                                        │
                    ┌─────────────┐
                    │     End      │
                    └─────────────┘
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 9133741 A
- JP 2010019664 A
- WO 2020045033 A
- JP 2018116839 A
- US 2020209319 A1